(19) Europäisches Patentamt
European Patent Office
Office européen des brevets

(11) **EP 2 590 889 B1**

(12) **EUROPEAN PATENT SPECIFICATION**

(45) Date of publication and mention
of the grant of the patent:
**20.12.2017 Bulletin 2017/51**

(51) Int Cl.:
**B81B 1/00** (2006.01)   **B81C 1/00** (2006.01)
**B81B 3/00** (2006.01)   **B05D 5/00** (2006.01)
**B05D 5/04** (2006.01)   **B05D 5/08** (2006.01)

(21) Application number: **11730333.9**

(22) Date of filing: **11.07.2011**

(86) International application number:
**PCT/EP2011/061778**

(87) International publication number:
**WO 2012/004415 (12.01.2012 Gazette 2012/02)**

(54) **SWITCHABLE SURFACES BASED ON FREELY FLOATING COLLOIDAL PARTICLES**

UMSCHALTBARE OBERFLÄCHEN AUF BASIS FREI FLIESSENDER KOLLOIDTEILCHEN

SURFACES COMMUTABLES BASÉES SUR DES PARTICULES COLLOÏDALES FLOTTANT LIBREMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.07.2010 EP 10169077**

(43) Date of publication of application:
**15.05.2013 Bulletin 2013/20**

(73) Proprietor: **Leibniz-Institut für Polymerforschung Dresden e.V.**
**01069 Dresden (DE)**

(72) Inventors:
• **IONOV, Leonid**
 **01187 Dresden (DE)**
• **PURETSKIY, Nikolay**
 **01069 Dresden (DE)**
• **STOYCHEV, Georgy**
 **01187 Dresden (DE)**
• **STAMM, Manfred**
 **01705 Freital (DE)**

(74) Representative: **Andrae | Westendorp Patentanwälte Partnerschaft**
**Uhlandstraße 2**
**80336 München (DE)**

• **BERGER S. ET AL: "Stimuli-Responsive biocomponent polymer janus particles by "Grafting from"/"Grafting to" approaches", MACROMOLECULES, vol. 41, 21 November 2008 (2008-11-21), pages 9669-9676, XP002615985,**
• **CHUNDER A ET AL: "Conformal switchable superhydrophobic/hydrophilic surfaces for microscale flow control", COLLOIDS AND SURFACES. A, PHYSICACHEMICAL AND ENGINEERING ASPECTS, ELSEVIER, AMSTERDAM, NL, vol. 333, no. 1-3, 5 February 2009 (2009-02-05), pages 187-193, XP025760623, ISSN: 0927-7757, DOI: DOI:10.1016/J.COLSURFA.2008.09.044 [retrieved on 2008-09-30]**
• **LIANG HONG ET AL: "Simple Method to Produce Janus Colloidal Particles in Large Quantity", LANGMUIR: THE ACS JOURNAL OF SURFACES AND COLLOIDS, AMERICAN CHEMICAL SOCIETY, WASHINGTON, DC, USA, vol. 22, no. 23, 17 October 2006 (2006-10-17), pages 9495-9499, XP002489699, ISSN: 0743-7463, DOI: DOI:10.1021/LA062716Z [retrieved on 2006-10-17]**

(56) References cited:
**EP-A1- 1 760 527        EP-A2- 1 857 865**
**US-A1- 2005 178 286**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

- RAMANAVICIENE A ET AL: "AFM study of conducting polymer polypyrrole nanoparticles formed by redox enzyme - glucose oxidase - initiated polymerisation", COLLOIDS AND SURFACES. B, BIOINTERFACES, ELSEVIER, AMSTERDAM, NL, vol. 48, no. 2, 15 March 2006 (2006-03-15) , pages 159-166, XP025136937, ISSN: 0927-7765, DOI: DOI:10.1016/J.COLSURFB.2006.02.002 [retrieved on 2006-03-15]

- TOKAREVA I. ET AL: "Nanosensors based on responsive polymer brushes and gold nanoparticle enhanced transmission surface plasmon resonance spectroscopy", JOURNAL OF THE AMERICAN SOCIETY, vol. 126, no. 49, 2004, pages 15950-15951, XP002615986,

**Description**

The invention relates to a switchable element comprising a substrate, a first material and colloidal particles; a method for the preparation of said switchable element; a method for preparing said switchable element having on a surface a pattern of at least one first area, wherein the colloidal particles have a first degree of immersion, and at least one second area, wherein the colloidal particles have a second degree of immersion different from said first degree of immersion; a method of physical switching said switchable element; and the use of said switchable element.

There is an increasing interest in chemistry surrounding the preparation, modification, physical characterization and manipulation of switchable surfaces on nanometer and micrometer scales, because said switchable surfaces can be potentially used in a wide spectrum of applications that range from optoelectronic devices to biological sensors.

Recently, surfaces with switchable/adaptive behavior have become an increasingly important material for design of microfluidic devices, sensors, functional coatings, logical devices and for biotechnological applications. These surfaces are very sensitive to any change in surrounding media, which can affect their optical parameters. Exploitation of this unusual phenomenon has given rise to new analytical and sensing techniques. To date, stimuli-responsive surfaces were designed mainly using self-assembled monolayers (SAM), polymer brushes or using metal oxides. Self-assembled monolayers have attracted considerable interest during the last decades and are formed spontaneously by immersing substrates in dilute solutions of amphiphilic molecules in appropriate solvents. A variety of film/substrate systems are known to lead to the formation of these highly ordered monolayer films.

Exposure to environmental stimulus or stimuli, such as solvent, pH, temperature and/or light (e.g. UV light), application of a magnetic field or an electrostatic charge, a change in capacitance and any combinations of the above, of these materials changes composition in the topmost surface layer that often affects wetting properties of a surface, which leads to changes in the e.g. optical and electrical properties of the topmost surface layer and therefore allows for various technical applications.

For example US 7,020,335 B2 reported the fabrication of a surface with reversible switchable properties comprising a nanolayer of a material, in particular a self-assembled monolayer. The nanolayer may include a plurality of molecular assemblies each having at least first and second information carriers. When an external stimulus is applied the nanolayer switches from a first confirmation state to a second confirmation state.

The switching range of wetting properties can be dramatically increased using rough substrates. According to equations of Wenzel (Wenzel, R. N. Ind. Eng. Chem. Res. 1936, 28, 988; Marmur, A. Langmuir 2003, 19, 8343; Marmur, A. Langmuir 2004, 20, 3517) and Cassie (Marmur, A. Langmuir 2003, 19, 8343; Cassie, A. B. D.; Baxter, S. Trans. Faraday Soc. 1944, 40, 546), roughness "enhances" intrinsic wetting properties of materials and makes hydrophilic/hydrophobic materials even more hydrophilic/hydrophobic.

Using this model, Minko et al. fabricated mixed hydrophobic-hydrophilic brushes grafted to rough substrates, which demonstrate very broad switching ranges between absolute wetting (water contact angle is close to 0°) and ultrahydrophobicity (water contact angle is more then 150°) (Minko, S.; Muller, M.; Motornov, M.; Nitschke, M.; Grundke, K.; Stamm, M. Journal of the American Chemical Society 2003, 125, 3896).

US 2007/0190299 A1 discloses the fabrication of a responsive coated substrate, said substrate comprising an interfacial surface to which a responsive coating attaches, said responsive coating comprising (a) at least one silicon-based, substantially hydrophobic polymer; and (b) at least one substantially hydrophilic polymer, wherein said responsive coating substrate is in a first state. The application of an external stimulus to said responsive coated substrate results in switching of said substrate from a first state to a second state.

US 2007/0190327 A1 relates to the fabrication of a responsive coated particle comprising at least one particle comprising an interfacial surface to which a responsive coating attaches, said responsive coating comprising (a) at least one silicone-based, substantially hydrophobic polymer; and (b) at least one substantially hydrophilic polymer, wherein said responsive coating particle is in a first state. The application of an external stimulus to said responsive coated particle results in switching of said particle from a first state to a second state. CHUNDER A ET AL: "Conformal switchable superhydrophobic/hydrophilic surfaces for microscale flow control", COLLOIDS AND SURFACES. A, PHYSICACHEMICAL AND ENGINEERING ASPECTS, ELSEVIER, AMSTERDAM, NL, vol. 333, no. 1-3, 5 February 2009 (2009-02-05), pages 187-193, XP025760623, ISSN: 0927-7757 discloses a switchable element comprising a substrate, a first material and colloidal particles, wherein the first material in a fluid state allows the colloidal particles to at least partially immerse into the first material and wherein the colloidal particles have a diameter between 20 nm and 500 nm. Further, Sidorenko et al. (Sidorenko, A.; Krupenkin, T.; Taylor, A.; Fratzl, P.; Aizenberg, J. Science 2007, 315, 487) reported that surface roughness and resulting wetting properties of composite hydrogels can be switched by deformation.

Although the above-described switchable elements are suitable for some applications, there is still a need for new switchable elements having improved properties, and there is still further a need for improved method for preparing an advantageous switchable element.

It is therefore an object of the present invention to provide a new type of a switchable element comprising a substrate, a first material and colloidal particles as well as a method for preparing said switchable element, which may be obtained easily and which avoids the disadvantages of the prior art.

According to a first aspect of the invention, this object is achieved by the switchable element according to claim 1. Preferred embodiments of the switchable element of the present invention are described in the dependent claims.

It has surprisingly been found that the object of the invention can be achieved by the preparation of a specific switchable element where roughness depending on the degree of immersion of the colloidal particles in the first material can be switched by an external stimulus. As a result, switchable elements comprising a substrate, a first material and colloidal particles can be obtained having improved properties compared to switchable elements already known in the art or prepared by known methods.

It has further unexpectedly been found that the surface properties of the switchable element can be frozen by cooling said element below the melting temperature of the first material.

According to a first aspect, the present invention thus provides a switchable element comprising a substrate covered by a first material and colloidal particles, which at least partially immerse into the first material, wherein the first material in a fluid state allows the colloidal particles to at least partially immerse into the first material, and wherein the colloidal particles are responsive to an external stimulus that changes their degree of immersion in the first material, and wherein at a temperature below the melting point of the first material the colloidal particles are fixed in their degree of immersion, wherein the first material is selected from the group consisting of polybutylvinylether, poly-cis-chlorobutadiene, polyethylene adipate, polyethylene oxide, poly-cis-isoprene, poly-trans-isoprene, propylene oxide, polyvinyl acetal or polyvinyl butyral, polyethylene or compositions or mixtures thereof, and of natural wax and synthetic wax, preferably paraffins, silicon waxes, polyether waxes and polyester waxes, or compositions or mixtures thereof and wherein the colloidal particles have a diameter between 20 nm and 500 nm.

There are no particular restrictions to the substrate, it may play a neutral role and may e.g. act only as a basis for a first material, i.e. as a solid material or support. However, the substrate may also take an active position and may act e.g. as an electrode. The substrate may have a reflective surface or may be provided with a metal layer, e.g. gold layer. The substrate preferably should have a regular planar surface such that a regular and defined structure of the switchable element may be obtained. Suitable substrates are e.g. a glass /quartz plate or a silicon wafer. However, other materials may also be used.

The substrate may be stiff or may be flexible and take e.g. the form of a thin foil. Such foil may be made, without limitation to those examples, from a metal, a metal oxide, or a plastic material, i.e. comprising an organic polymer. The substrate may be formed homogeneously of a particular material. However, it is also possible to use a substrate comprising several layers made of different materials. An example for such a substrate is e.g. a silicon wafer, on top of which is provided a layer of silicon dioxide.

According to an embodiment of the present invention, any substrate, including all classes of materials, such as metals, ceramics, glasses, non-crystalline materials, semiconductors, polymers and composites may be used in the present invention. Substrates may also be combined with each other, e.g. a substrate of one material may be coated or patterned with a second or different material.

The term "colloidal particles" refers to single microparticles and nanoparticles or aggregates of particles. As described herein, the colloidal particles are capable of at least partially immersion into the first material as described herein. According to one embodiment of the invention, the colloidal particles can have an additional functionality and can for example be used for a desired technical application, e.g. act as an electrode. The colloidal particles can e.g. comprise a reflective surface or a metal layer, a semiconductor layer or a magnetic layer coating, allowing usage of Surface Plasmon Resonance or UV-Vis spectroscopy or fluorescence spectroscopy as an analytical tool for detecting e.g. a stimulus. For some applications it can be suitable to use an isolating material for the colloidal particles, e.g. metal oxide or a material that has photo-luminescent properties or fluorescent properties. The material of the colloidal particles may be selected depending on the technical application for which the switchable element is used. According to one embodiment, the colloidal particles are not covered with a polymer on only one side thereof or with different polymers on opposite sides.

Colloidal particles suitable for the present invention have a mean diameter within the range of 20 nm to 500 nm. The size of the colloidal particles is selected depending on the technical application for which the colloidal particles are used. Preferably the colloidal particles have a mean diameter in the range of from 50 nm to 300 nm. The diameter is the largest dimension of a particle. The mean value is the arithmetic mean value.

In a further preferred embodiment, the colloidal particles have a narrow size distribution. Preferably, more than 80 % by number of the particles have a size within a range of $\pm$ 25 %, further preferred of $\pm$ 10 % of the mean diameter of the particles. The size of the particles may be determined e.g. by TEM (Transmission Electron Microscopy), DLS (Dynamic Light Scattering), SEM (Scanning Electron Microscopy) or AFM (Atomic Force Microscopy).

The colloidal particles preferably have a spherical shape but can also have another shape, e.g. the shape of a small platelet or a rod. Further preferred, the colloidal particles have a branched shape such as tetrapod. Alternatively, the colloidal particles can also have an irregular morphology. The colloidal particles can be massive or can be hollow. An example for hollow particles is e.g. a fullerene or a carbon nanotube. Massive colloidal particles having a spherical shape are preferred.

As already discussed, the colloidal particles according to the present invention may be made from any kind of material. According to a preferred embodiment, the colloidal particles consist of materials selected from silica or other oxides or hydroxides, e.g. $TiO_2$, $In_2O_3$, $ZnO$, $Fe_3O_4$, $Fe_2O_3$, magnesium hydroxide, aluminium hydroxide, metal, e.g. gold, silver, copper, platinum and alloys thereof, semiconductor e.g. CdSe, CdS, CdTe, $CuInS_2$, ZnS, ZnSe, ZnTe, PbS, PbSe, PbTe, Si, $HgI_2$, $In_2S_3$, $In_2Se_3In$, $In_2Te_3$, $Cd_3P_2$, $Cd_3As_2$, InAs, InP, GaP, GaAs, non-conductive materials or compositions or mixtures thereof.

According to a further preferred embodiment, the colloidal particles are inorganic or organic particles, wherein the inorganic particles are preferably selected from the group consisting of metals, metal oxides, metal hydroxides, semiconductor materials, non-conductive materials and silica, preferably FeO, $Fe_2O_3$ and $SiO_2$, or compositions or mixtures thereof; and

wherein the organic particles are preferably polymer or (co)polymer particles, which are preferably selected from the group of thermoplastic materials comprising polystyrene, polyolefins, in particular polyethylene or polypropylene; polyacrylates, polymethacrylates; polyimides, polycarbonates, polyethersulfones, polyamides, polyesters; and polyvinyl chlorides; styrene-butadiene rubber (SBR); styrene-ethylene-butadiene-styrene copolymers (SEBS); butyl rubber; ethylene-propylene rubber (EPR); ethylene-propylene-diene-monomer rubber (EPDM); ethylene-vinyl acetate copolymer (EVA); ethylene-acrylate or butadiene-acrylonitrile; maleic anhydride modified polymers and copolymers; and graft copolymers; or compositions or mixtures thereof.

According to a further preferred embodiment of the invention, the colloidal particles may be unmodified or modified particles. The term "unmodified particles" refers to the particles, wherein no functionalization step comprising bearing chemically reactive moieties to the surface of the particles was used.

According to an another preferred embodiment of the invention, the colloidal particles are functionalized ("modified particles") with at least one reactive group in order to, for example, decrease aggregation of the colloidal particles. An exemplary compound that may be used in the present invention to modify particles is a silane derivative, preferably 3-aminopropyl-triethoxysilane or 3-glycidoxypropyl trimethoxysilane.

According to the present invention, the term "first material" refers to a substance which behaves as a solid under certain conditions and as a fluid under other conditions. According to one embodiment, it may behave as a fluid under an applied stress, e.g. temperature or pressure, or as a solid or semi-solid then this stress is not applied anymore.

According to the invention, the first material is selected from polymers and waxes as defined by claim 1.

Waxes are water insoluble, organic materials that are solid or semi-solid at a temperature between 22 and 25°C (room temperature), usually of lower density than water, and typically can be melted above said temperature to form a fluid. Preferred waxes include any unmodified or modified naturally occurring and synthetic waxes, wax esters, and greases. Modified waxes according to the invention are (without limitation) e.g. selected from the group consisting of various plant derived waxes, greases and oils including carnauba wax, cranberry wax, ouricuri wax, candelilla wax, raphia wax, apple, cotton and cactus waxes; waxes (including greases) produced by bacteria (for example, cetylstearate); fungi, protozoa and algae; various invertebrate waxes and greases including insect waxes such as beeswaxes (for example, triacontylpalmitate, palmatylpalmitate), and Coccus sp. derived waxes (for example, lac, cochineal and Chinese insect); and other animal fats (for example, triglycerides) and waxes including spermaceti (for example, cetylpalmitate), lanolin and wool grease. Also included are derivatives, extracts, and combinations of these materials.

The term "polymer" according to the present invention means e.g. a homopolymer and (co)polymer having from 2 to 50,000 repeating units, which may include block, random, alternate or gradient (co)polymers or combinations thereof and have wax-like chemical or physical properties. Polymers may also be combined with other above-mentioned waxes. In the melt, polymer or (co)polymer interfaces can be considered as "fluid" with dynamics much slower than for conventional liquids.

According to the invention, the first material is selected from the group consisting of polybutylvinylether, poly-cis-chlorobutadiene, polyethylene adipate, polyethylene oxide, poly-cis-isoprene, poly-trans-isoprene, propylene oxide, polyvinyl acetal or polyvinyl butyral, polyethylene or compositions or mixtures thereof; and of natural wax and synthetic wax, preferably paraffins, silicon waxes, polyether waxes and polyester waxes, or compositions or mixtures thereof.

The melting temperature or melting point is an important characteristic of the first material of the present invention in the sense that the first material is capable of reaching a fluid or liquid-like state in which the colloidal particles can at least partially immerse in the first material. The term "melting point", when applied to the first material, suggests not a solid-liquid phase transition but a transition from a solid or semi-solid state to a fluid (liquid-like) state. In a further preferred embodiment, the first material has a melting temperature from 25°C to 150°C, preferably from 30 to 85°C, particularly preferred from 35 to 65°C. Further preferred, the first material is non-reactive with the reagents or solvents to which it is exposed.

The switchable element according to the invention comprises a substrate covered by a first material and colloidal particles, which at least partially immerse into the first material.

The term "immersion" or "immersed colloidal particles" refers to the colloidal particles, which are partially immersed or incorporated / integrated into the first material.

The term "degree of immersion" (H) refers to a height of particles above the surface of a first material. In particular, the degree of immersion may be determined using different analytical techniques such as contact angle measurement, AFM or other kind of specific microscopes known to the skilled person.

According to a preferred embodiment of the invention, the degree of immersion of the colloidal particles in the first material is between 0 and 100 %, preferably between 5 and 95 %.

According to one embodiment of the invention, the surface of the switchable element according to the present invention can be further modified on nanometer, micrometer or higher scale to generate a patterned surface. The term "pattern" refers to a specific structure of a surface, which, according to a preferred embodiment, repeats on this surface in a predictable manner. For example, a template or a special mask can be used to generate said specific structure or a part of said structure. According to one embodiment, the patterns are based on repetition and reproducibility.

According to another embodiment of the invention, the switchable element provides a surface of a pattern of at least one first area, wherein the colloidal particles have a first degree of immersion, and at least one second area, wherein the colloidal particles have a second degree of immersion different from said first degree of immersion.

Such patterns may have any desired form and are advantageous to provide different areas or spots having different surface properties.

According to a preferred embodiment of the invention, the degree of immersion of the colloidal particles in a first area (on the surface) of the switchable element is different from the degree of immersion in a second area of the switchable element.

According to a further preferred embodiment of the invention, the first area and second area are arranged in a pattern at the surface of the switchable element.

According to one aspect of the invention, a switchable element is provided wherein a substrate (as described herein) is coated with a first material (as described herein). Preferably, the first material forms a layer directly on the surface of the substrate, preferably only on one surface or side of the (planar) substrate. Preferably, in the switchable element of the invention, the colloidal particles (as described herein) are partially immersed in the first material, but not completely covered by or immersed in the first material. Thus, according to this aspect of the invention, the colloidal particles can change their degree of immersion in the first material when the first material is in a molten state. Preferably, the colloidal particles do not form a layer between the substrate and the first material. Thus, preferably the colloidal particles are present (partially immersed) on the surface of the first material (layer) facing the ambient medium, but not the surface facing the substrate. Thus, a preferred sequence of "layers" in the switchable element of the invention is: substrate, first material, colloidal particles (partially immersed in the first material).

The invention is further directed to a method for the preparation of a switchable element according to the invention, comprising the steps of:

(a) providing colloidal particles, a first material and a second material;

(b) providing an emulsion comprising the colloidal particles, the first material and the second material from step (a);

(c) forming first material particles comprising colloidal particles from the emulsion;

(d) applying the first material particles comprising colloidal particles to the surface of a substrate;

(e) melting the first material particles comprising colloidal particles on the surface of the substrate,

wherein the second material is any material which is substantially immiscible with the first material, and wherein following melting the first material particles comprising colloidal particles in step e), the first material is solidified to fix the particles in or on the first material.

In step (a) of the method according to the invention, the colloidal particles, a first material and a second material are provided.

The term "second material" refers to any material which is substantially immiscible with the first material, i.e. forms a separate phase and preferably does not solidify under the same conditions as the first material.

According to a preferred embodiment of the invention, the second material is selected from the group consisting of water, organic solvents, organic solutions and inorganic solutions. Particularly preferred the second material is water. Preferred inorganic solutions include water-based solutions comprising an inorganic acid or base. Examples of inorganic acids include hydrochloric acid, sulfuric acid, nitric acid, phosphoric acid, hydrobromic acid and boric acid. Examples of inorganic bases include potassium hydroxide, sodium hydroxide, lithium hydroxide and ammonium hydroxide. Preferred organic solutions include water-based solutions comprising an organic acid. Examples of organic acids include formic acid, acetic acid and citric acid. Preferred organic solvents include dicloro-methane, tetrahydrofuran, ethyl acetate, acetone, dimethylformamide, acetonitrile, dimethylsulfoxide and alcohols, e.g. n-butanol, n-propanol, ethanol and methanol, hydrocarbons including alkanes such as dodecane and hexadecane, aromatic hydrocarbons including toluene and benzene, other similar solvents and combinations thereof. The choice of the second material selected is dependent on the nature of the first material and the colloidal particles used to form an emulsion.

In step (b) of the method according to the invention, an emulsion comprising the colloidal particles, the first material and the second material from step (a) is formed / provided.

The term "emulsion" refers to a combination of at least two components, wherein one of the components is present in the form of droplets in the other component. The emulsion can be obtained by mixing or stirring the corresponding components and with or without adding subsequent stabilizing agent. The components may be added to each other simultaneously or consecutively. On the other hand, two components may be at first mixed together and then added to the third component.

In step (c) of the method according to the invention, the first material particles comprising colloidal particles are formed from the emulsion. In other words, particles are formed comprising the first material and the colloidal particles.

The emulsion is formed by adding or otherwise suspending colloidal particles and the first material in the second material, or otherwise combining those components. The first material is in the form of small drops or droplets and is substantially immiscible in the second material. The emulsion is made at a temperature where the first material is in a molten (liquid or fluid) state. In the process of coating the surface of the droplets comprising the first material with the colloidal particles, the colloidal particles self-assemble at the interface between the two materials. The self-assembling is generally driven by the minimization of total interfacial energies, in particular first material/second material, first material/colloidal particles, second material/colloidal particles. According to a preferred embodiment of the invention, at least about 90%, preferably at least about 95%, particularly preferred at least about 99% of the surface area of the droplets comprising the first material is covered with colloidal particles.

The first material particles comprising colloidal particles (colloidosomes) may then be stabilized in a variety of ways. For example, the particles may be linked to each other by van der Waals forces or other electrostatic interactions, with use e.g. of chemical cross-linking agents for interfacial cross-linking. The latter processes can lead to physical linking or attachment of the particles to each other. According to a further preferred embodiment of the invention, the colloidal particles are linked by cross-linking between reactive surfaces of neighboring particles. In another preferred embodiment of the invention, the emulsion comprising the first material particles comprising colloidal particles is stabilized by adding a surfactant or a polyelectrolyte.

After that the emulsion is cooled down to a temperature sufficiently low to fix the colloidal particles at the first material / second material interface and thus to form the first material particles comprising colloidal particles, preferably below the solidification point of the first material, e.g. down to a temperature of 25°C or below. Preferably, the first material particles comprising colloidal particles are separated from the second material by known means. According to one embodiment, this may be easily achieved if the second material is in a liquid state (and the first material particles are solidified).

In step (d) of the method according to the invention, the first material particles comprising colloidal particles are brought into contact with the surface of a substrate.

According to the invention, several techniques, in particular horizontal- and vertical-deposition techniques, can be used for the preparation of a layer of the first material particles comprising colloidal particles on the surface of a substrate. Preferably, the second material is removed in the process.

In the horizontal-deposition technique, an emulsion comprising the first material particles comprising colloidal particles and the second material are deposited on the surface of a substrate. Afterwards, the second material is (partially) e.g. evaporated. In this way, a well-ordered layer comprising the first material particles comprising colloidal particles on the surface of a substrate was obtained.

In the vertical-deposition technique, e.g. the homogeneous formation of a layer, in particular a monolayer, can be successfully achieved by immersing and carefully withdrawing from the corresponding emulsion a substrate, thus forming a layer of first material particles comprising colloidal particles on the substrate. According to this technique, the substrate to be coated is immersed in an emulsion and withdrawn vertically at a well defined speed. In this case, the withdrawal rate of a substrate equals to the layer formation rate. This technique allows preparing homogeneous, well-ordered layer comprising the first material particles comprising colloidal particles.

In step (e) of the method according to the invention, the first material particles comprising colloidal particles are melted on the surface of the substrate in order to obtain a switchable element.

The melting of the first material particles comprising colloidal particles on a substrate surface can be done under different conditions depending on the properties of a switchable element to be achieved, preferably:

(a) Melting the first material particles comprising colloidal particles in a dry ambient medium, e.g. in air, leads to formation of a switchable element, wherein the particles are deeply immersed in the first material, thereby providing a hydrophobic surface.

(b) Melting the first material particles comprising colloidal particles in a liquid ambient medium, e.g. in water, leads to formation of a switchable element, wherein the particles are only slightly immersed in the first material, thereby providing a hydrophilic surface.

Thus, in principle, the melting can be done under any desired condition and using any ambient medium. E.g. the ambient medium can be liquid or gaseous (or dry). If the ambient medium is e.g. air, for example the degree of humidity can be varied. As explained further below, depending on the ambient medium chosen, the degree of immersion of the colloidal particles in the first material can be varied.

Following melting the first material particles comprising colloidal particles in step e), the first material is preferably solidified (e.g. by cooling) to "fix" the particles in/on the first material. Thus, if the first material is solidified, the colloidal particles are fixed in their state of immersion, whereas their degree of immersion can be adjusted in the molten state of the first material, depending on the ambient medium and conditions.

Interfacial particle-containing elements in particular at nanometer and micrometer scales can be used to generate micropatterned solid surfaces, which have potential applications in microelectronic, optic and biological microanalysis. A further object of the invention therefore is directed to a method for preparing a switchable element according to the present invention, having on a surface at least one first area, wherein the colloidal particles have a first degree of immersion, and at least one second area, wherein the colloidal particles have a second degree of immersion different from said first degree of immersion, the method comprising:

(a) providing a switchable element according to the invention;

(b) treating the first area(s) but not the second area(s), or the second area(s) but not the first area(s) with at least one external stimulus in order to change the degree of immersion of the colloidal particles on the treated area(s) and to produce the pattern on the surface of the switchable element.

The first and second areas, respectively, or a pattern of such areas according to the present invention, are formed on the surface of the already formed switchable element by treating the first or the second area(s) with at least one external stimulus in order to change the degree of immersion of the colloidal particles. Controlled manufacturing of the areas and patterns, respectively, can be achieved by treating with at least one external stimulus under controlled conditions. In this way, several types of areas or patterns from various colloidal particles can be reproducibly prepared using local treatment with a stimulus such as temperature (e.g. hot needle or laser beam), radiation (e.g. UV- or IR-radiation), humidity (e.g. water steam), solvent or combination thereof.

The method according to the invention might be used, for example, to form areas or precise patterns containing areas that have hydrophobic properties and other that have hydrophilic properties. Depending on the design of such patterns, specific cells or molecules will stick to the switchable element. Such a technology can e.g. be used in the laboratory for speedy chemical or genetic screening of blood and other biological materials.

The switchable element according to the invention may be used to detect a stimulus, such as temperature, radiation or humidity. A further object of the invention is directed to a method of physical switching the switchable element according to the present invention, comprising the steps of:

(a) providing the switchable element;

(b) applying at least one external stimulus to the switchable element;

wherein the switchable element responds to the at least one external stimulus by changing the degree of immersion of the colloidal particles in the first material.

According to one embodiment, it has surprisingly been found that modified and unmodified colloidal particles deeply immerse in the first material after treatment with an external stimulus, in particular when applying a temperature above the melting point of the first material, in dry environment (e.g. absence of water in the ambient medium). Further, the colloidal particles e.g. immerse only slightly in the first material when applying temperature and in the presence of water in the ambient medium. Thus, the surface properties of the switchable element can be switched, in particular reversibly switched, between hydrophobic and hydrophilic states by applying at least one external stimulus.

As discussed above, according to a first aspect of the invention, a switchable element is provided. The suitable embodiment of the switchable element is selected according to the analytical problem to be solved, in particular the stimulus to be applied to the switchable element. According to a preferred embodiment of the invention, the external stimulus is selected from the group consisting of temperature, radiation, preferably UV- of IR-radiation, humidity and presence or absence of water in the ambient medium surrounding the switchable element. For detecting e.g. the presence or absence of water or determining humidity, it is e.g. possible to select a switchable element comprising non-patterned or patterned surface. The colloidal particles comprised in the switchable element may be selected e.g. according to the physical parameter of the switchable element used to detect the presence or absence of a stimulus.

To obtain a reference value, the corresponding physical parameter of the switchable element, such as degree of immersion of the colloidal particles in the first material, is detected in the absence of the stimulus. A reference value may be obtained from a switchable element in a dry state or from a switchable element in a defined state. The determination of a reference value may be interpreted as calibration of the switchable element.

The switchable element is then contacted with at least one external stimulus to be determined. After obtaining equilibrium between the switchable element and applied stimulus, the degree of immersion of the colloidal particles in the first material is determined again thereby obtaining a measured value. The presence, absence or intensity of the stimulus may then be determined by comparing the reference value and the measured value.

It has been unexpectedly found that the properties of the switchable element obtained by using the method(s) according to the invention have improved properties with respect to wide ranging applications in the field physic, chemistry, semiconductor technology, biology, biotechnology and medicine.

The present invention is therefore also directed to the method of using of a switchable element according to the invention in optoelectronic, sensor or biotechnological applications.

Preferably, the present invention is directed to the method of using of a switchable element according to the invention for the design of microfluidic devices, functional coatings, logical devices or a pattern. In particular, the present invention is directed to the method of using of a switchable element for design of switchable surfaces for offset printing of pigments, proteins as well as cells.

Microfluidics is a new technology platform that deals with the behavior, precise control and manipulation of fluids that are geometrically constrained to a small, typically sub-millimeter, scale. In particular, the term "microfluidic device" refers to a device comprising one or more channels with at least one dimension less than 1 mm. Microfluidic systems analyze by controlling the flow of liquids or gases through a series of tiny channels and valves, thereby sorting them, much as a computer circuit sorts data through wires and logic gates. This allows them to handle biological materials such as DNA, proteins or cells in minute quantities - usually nano-liters or pico-liters (1000 times smaller than a nano-liter). Microfluidic devices can be used to obtain a variety of interesting measurements including molecular diffusion coefficients, fluid viscosity and chemical binding coefficients. Other applications for microfluidic devices include capillary electrophoresis, isoelectric focusing, immunoassays, flow cytometry, sample injection of proteins for analysis via mass spectrometry, cell manipulation, cell separation and cell patterning.

Functional surface coating is now widely recognized as an enabling technology of major importance in the successful, effective, and efficient exploitation of materials in e.g. engineering practice. The term "functional coating" refers to a system which possesses, besides the classical properties of a coating, an additional functionality. This additional functionality may be diverse, and depend upon the actual application of a coated substrate. Creation and synthesis of advanced and novel materials, functional coating may be broadly regarded as embracing activities such as surface properties optimization, as an integral part of the design process and synthesis and fabrication technologies.

The term "logical device" refers to an electronic component used in electronic industry.

According to a further aspect, the present invention is directed to the use of first material particles comprising colloidal particles as described herein, for the preparation of a switchable element, wherein the switchable element further comprises a solid substrate carrying the first material.

The invention will now be described in more detail by way of non-limiting examples and with reference to the accompanying figures:

Fig. 1.   schematically shows switching of the first material / colloidal particles surface.

Fig. 2.   shows switching of the switchable element comprising unmodified silica particles as colloidal particles, wax as a first material and silicon wafer as a substrate; AFM (second from left) and SEM (third from left) images of silica particles on wax surface.

Fig. 3.   shows simulated (a) and experimentally obtained (b-d) wetting properties of the switchable element, in particular particle/wax surfaces, after annealing in dry and aqueous environment:

(a) - simulated water contact angle on unmodified (dotted and dash-dotted lines) and APS-coated (dashed and solid lines) wax-particle surfaces after annealing in air (solid lines) and under water (dashed lines) at different surface coverage of wax surface by the particles; water contact angles after annealing in air and in water of (b) wax-silica particle surface; (c) wax-APS-modified silica particle surface; (d) reference wax surface.

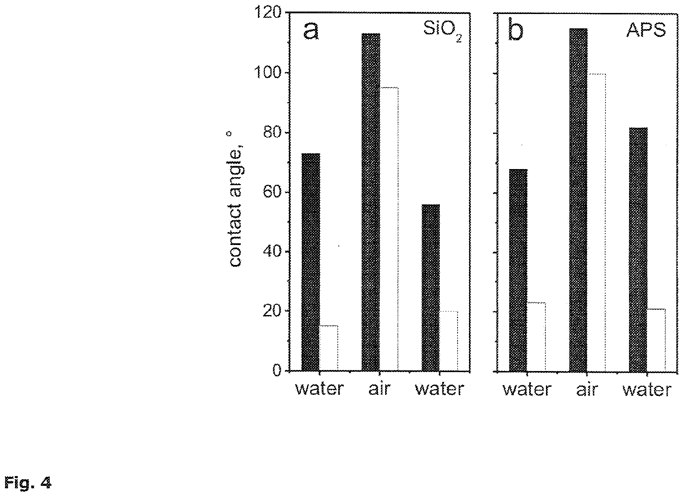

Fig. 4.   shows switching of water contact angles on wax-silica particles (a) and wax-APS particles (b) surfaces after sequential annealing in water, in air and in water again.

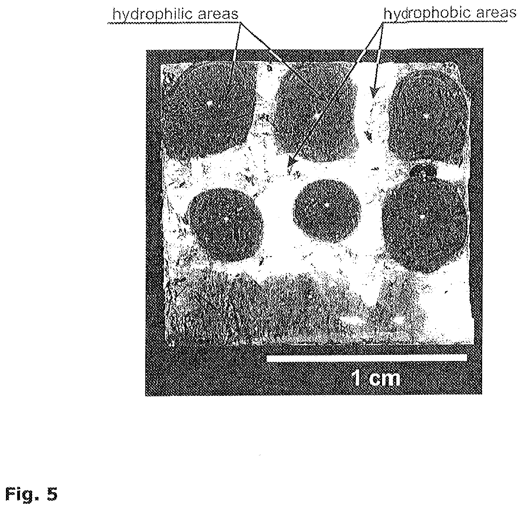

Fig. 5.    shows APS-particle/wax patterned surface.

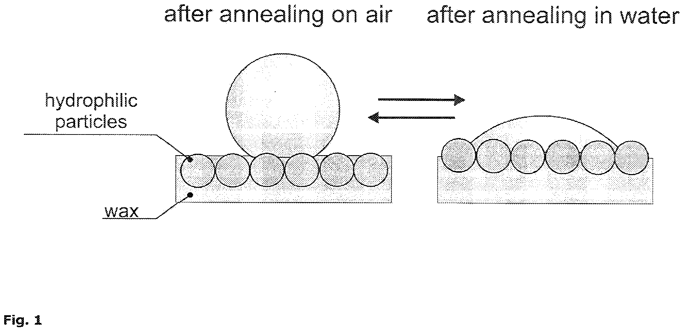

Fig. 1. schematically shows switching of the first material / particle surface of the switchable element, in particular wax-particle surface, wherein the hydrophilic particles were mixed with hydrophobic wax (the first material). Annealing in water and in air changes the degree of immersion (depth of immersion) of the particles in wax layer that switches properties of the layer between hydrophilic and hydrophobic states.

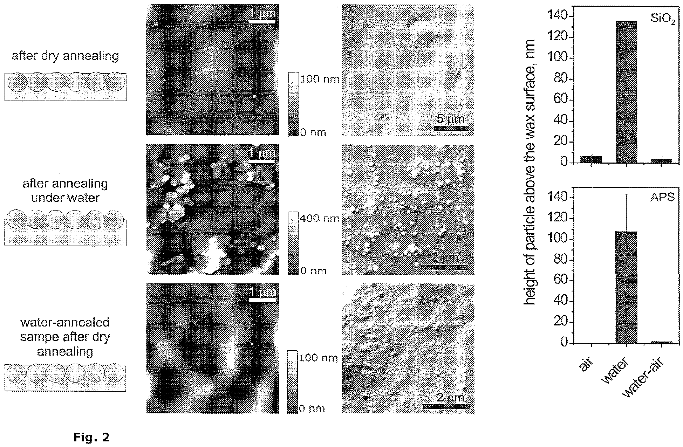

Fig. 2. shows switching of the switchable element comprising unmodified silica particles as colloidal particles, wax as a first material and silicon wafer as a substrate. Three panels show changing the degree of immersion of unmodified silica particles in wax: after annealing on air (upper panel), annealing in water (middle panel) and annealing on air of the sample preliminary annealed in water (lower panel). Corresponding AFM (second from left) and SEM (third from left) images show the surface of the switchable element.

Immersion state of the silica particles (height of the particles above wax surface, nm) after annealing on air, under water and after second annealing on air of unmodified and APS-modified silica particles was derived from AFM images (right plot).

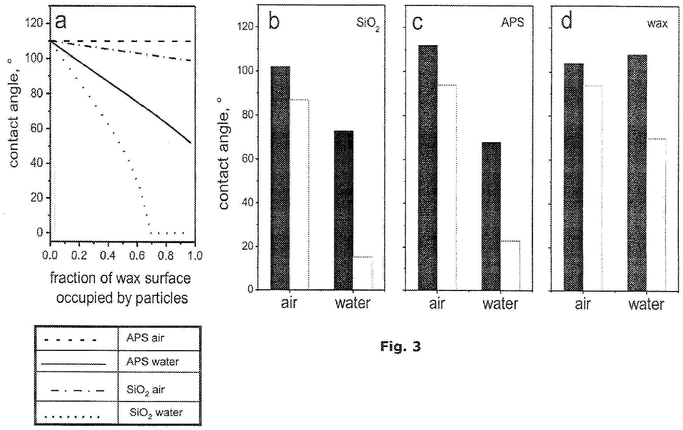

Fig. 3. shows differences in hydrophobisity / hydrophilicity of modified and unmodified with APS silica particles upon treating said particles with one external stimulus such as temperature and with two external stimulus such as temperature and water (ambient medium).

Fig. 4. shows reversible switching of the switchable elements comprising wax-silica particle (a) and wax-APS particle (b) on silicon wafer as a substrate.

Fig. 5. shows hydrophilic/hydrophobic patterning of APS-particle/wax surface using heated needle. APS-particle/wax surface was switched to hydrophilic state by annealing in aqueous environment. Applying heated needle locally switches the surface into hydrophobic state. Water (colored with rhodamine) selectively wets the hydrophilic areas and is unable to wet the areas where the need was applied.

## Examples

Example 1: Preparation of modified silica particles:

200 nm silica particles were washed three times in dichloromethane followed by drying in vacuum oven at 110°C. 3-aminopropyltriethoxysilane (APS) was chemisorbed from a 2wt.-% ethanol solution for 24 hours. To remove nonadsorbed APS, the particles were rinsed and centrifuged five times in ethanol.

Example 2: Fabrication of the switchable element:

0.2 g of unmodified (native) or 3-aminopropyltriethoxysilane (APS)-modified 200 nm silica particles was dispersed homogeneously in 1 g of paraffin wax at 75°C and then mixed with 10 g of Millipore water. The emulsions were produced using magnetic stirring at 1600 rpm for 1 hour and then were cooled to room temperature (25°C), at which paraffin wax is solid. Deionized water was used to wash the wax emulsions multiple times to remove particles in the aqueous solution as well as weakly attached particles.

The resulting emulsion was melted on water surface at T=60°C and cooled down to T=20°C. The formed film was then brought in contact with a silicon wafer.

Then, the coated substrate was heated up to a temperature of 60°C to melt the paraffin wax and to allow the silica particles to migrate through the paraffin wax to the surface of the switchable element.

Example 3: Effect of gravity on the degree of immersion of the colloidal particles

Silicon wafers coated with the layer comprising paraffin wax / silica particles (both modified and unmodified silica particles) were prepared according to Example 2. One part of said coated silica wafers was positioned horizontally and another part was positioned vertically. Both parts were heated up to a melting point of the paraffin wax (57-59°C). Degree of immersion of the silica particles in the paraffin wax has been studied using Atomic Force Microscopy (AFM).

It was observed that the particles were virtually completely immersed in wax in both cases resulting in no influence of gravity on the degree of immersion of the particles. In agreement with experimental results, theoretical calculation predicts that interfacial forces acting on 200 nm large particles are ca. $10^{-10}$ N that dramatically exceeds the gravity force, which is estimated to be ca. $10^{-19}$ N.

Example 4: Switching of the switchable element

A switchable element was prepared according to Example 2. Treating with a temperature of 57-59°C was done in aqueous (under water) and dry (in air) environments. It has been found (see Fig. 2) that both unmodified and APS-modified silica particles were almost completely immersed into wax at the wax-air interface. On the other hand, particles were found to be only slightly immersed in wax at the water-wax interface. The degree of immersion (H) of unmodified and APS-modified particles is different - H = 35% and H = 45%, respectively, which is in good qualitative correlation with our estimation based on contact angle data (Table 1 and 2) using formula

$$H = 100\% \cdot (\cos \Theta + 1)/2$$

(Synytska, A.; Ionov, L.; Dutschk, V.; Stamm, M.; Grundke, K. Langmuir 2008, 24, 11895).

Table 1. Experimentally measured values of contact angles at different interfaces.

| interface | water contact angle, ° | interface | hexadecane contact angle, ° |
|---|---|---|---|
| APS-water-air | 70 | $SiO_2$-hexadecane-air | 0 |
| $SiO_2$-water-air | 43 | $SiO_2$-hexadecane-water | 154 |
| Wax-water-air | 107 | APS-hexadecane-air | 0 |
| | | APS-hexadecane-water | 122 |

Hexadecane contact angles in aqueous environment were calculated as difference of 180° and water contact angle on wafer immersed in hexadecane.

Table 2. Experimentally obtained and estimated degree of immersion of unmodified and APS-modified silica particles in wax depending on the environment.

| particles | annealing conditions | degree of particle immersion in wax, % | |
|---|---|---|---|
| | | experimental | estimated using contact angles from Table 1 |
| unmodified | air | 95 | 100 |
| | water | 35 | 5 |
| APS-modified | air | 100 | 100 |
| | water | 45 | 23 |

Example 5: Wetting properties of composite wax-particle surfaces

The switchable element was prepared according to Example 2. Wetting properties said switchable element comprising composite wax-particle surface have been investigated in theoretical and experimental way as shown below.
The wetting properties of wax-particle surface are determined by several parameters: hydrophobicity and surface roughness provided by the particles as well as hydrophobicity of the wax. Although there are many models, which may be used to simulate wetting behavior of wax surfaces with particles, we applied the Cassie-Baxter equation (1).
For simplicity, only the case is considered when the water droplets collapsed on the surface. In this case, liquid completely fills the grooves between particles (collapsed drop) that leads to low receding angle. The following modification of the Cassie-Baxter equation was used:

$$\cos\Theta = f_{particle}^{wax} \cdot r_{particle}^{wax} \cdot \cos\Theta_{particle}^{water} + \left(1 - f_{particle}^{water}\right) \cdot \cos\Theta_{wax}^{water} \tag{1}$$

, where $\cos\Theta_{particle}^{water}$ and $\cos\Theta_{wax}^{water}$ are the intrinsic water contact angles on the particle and wax surfaces, respectively;

$f_{particle}^{wax} = n\pi R_p^2\left(2h^* - h^{*2}\right)$ is the area fraction of particles on the surface of wax;

$$r_{particle}^{wax} = \frac{2}{2 - h^*}$$ is roughness factor of particle cap above wax surface;

$$f_{particle}^{water} = n\pi R_p^2 \left(1 - \cos\Theta_{particle}^{water\ 2}\right)$$ fraction of water surface in contact with the particle caps;

$$h^* = 1 - \cos\Theta_{wax}^{air\ -\ or\ -\ water}$$ is normalized height of particle cap immersed in wax;

$$n = \frac{N}{S}$$ is the number of particles (N) per areas (S);

$$n_{max} = \frac{1}{2\sqrt{3}R_p^2}$$ is maximum number density of particles on surface, which corresponds to closely packed particles.

Performed simulations demonstrate that the unmodified (native) and APS-modified particle-wax surfaces provide different wetting properties after annealing on air and in water, i.e. the particle-wax surface is hydrophilic after annealing in water and is hydrophobic after annealing in air. The contrast between hydrophilic and hydrophobic states increases with the density of particles on the surface (Fig. 3a).

Experimental investigation of the wetting properties on obtained wax-particle layers after annealing in different media was performed using water contact angle measurements. It was found that the wax-particle surface is more hydrophilic after annealing in water then after annealing on air (Fig. 3b, c). Due to small contact angle hysteresis the water droplets are relatively flexible on the wax-particle surface annealed on air and can be removed by slight shaking. On the other hand, the water droplets remain strongly pinned to wax-particles surface annealed in water. We performed a control experiment and investigated wetting properties of wax (without particles) annealed on air and in water. The wax surface becomes slightly more hydrophilic after annealing in aqueous environment which is seen from the expresses in decrease of the receding contact angle (Fig. 3d). The advancing water contact angles on the wax surfaces annealed in dry and aqueous environments are nearly the same. Therefore, it can be concluded that the difference in wetting properties of wax-particle surface annealed at different conditions originates from the different degrees of immersion of particles into wax surface.

Example 6: Reversible switching of the switchable element

The switchable element was prepared according to Example 2. The reversible switching of the switchable element is shown in Fig. 4. The hydrophilic wax-particle film, which was preliminary annealed in water, was used for the switching experiments. This film was melted in a dry state. It was found that the particle-wax films switch into hydrophobic state after annealing in air. The second annealing in water switches the layer back into the hydrophilic state. Thus, the wax-particle layer demonstrates fully reversible switching of wetting properties after annealing in dry and aqueous environment.

Example 7: APS-particle/wax patterned surface

The switchable element, which was preliminary switched to hydrophilic state by annealing in water (prepared according to Example 2) was used to study the applicability of the developed stimuli-responsive surfaces for hydrophilic-hydrophobic patterning. As an external stimulus a hot needle was locally applied to the surface of the switchable element. As expected (Fig. 5), a locally applied hot needle switches the particle-wax surface to hydrophobic state. In fact, it has been found that water readily wets areas where no needle was applied (hydrophilic areas) while water does not wet the areas where the needle was applied (hydrophobic area). In this way it was possible to produce a patterned structure on the surface of the switchable element.

**Claims**

1. A switchable element comprising a substrate covered by a first material and colloidal particles, which at least partially immerse into the first material,
   wherein the first material in a fluid state allows the colloidal particles to at least partially immerse into the first material, and wherein the colloidal particles are responsive to an external stimulus that changes their degree of immersion in the first material, and wherein at a temperature below the melting point of the first material the colloidal particles are fixed in their degree of immersion,
wherein the first material is selected from the group consisting of polybutylvinylether, poly-cis-chlorobutadiene, polyethylene adipate, polyethylene oxide, poly-cis-isoprene, poly-trans-isoprene, propylene oxide, polyvinyl acetal or polyvinyl butyral, polyethylene or compositions or mixtures thereof, and of natural wax and synthetic wax, preferably paraffins, silicon waxes, polyether waxes and polyester waxes, or compositions or mixtures thereof and wherein the colloidal particles have a diameter between 20 nm and 500 nm.

2. The switchable element according to claim 1, wherein the melting temperature of the first material is from 25 to 150°C, preferably from 30 to 85°C.

3. The switchable element according to any of claims 1 to 2, wherein the degree of immersion of the colloidal particles in a first area on the surface of the switchable element is different from the degree of immersion in a second area on the surface of the switchable element.

4. The switchable element according to claim 3, wherein first area and second areas are arranged in a pattern at the surface of the switchable element.

5. The switchable element according to any of claims 1 to 4, wherein the colloidal particles are inorganic or organic particles,
wherein the inorganic particles are preferably selected from the group consisting of metals, metal oxides, metal hydroxides, semiconductor materials, non-conductive materials and silica, preferably FeO, $Fe_2O_3$ and $SiO_2$, or compositions or mixtures thereof; and
wherein the organic particles are preferably polymer or (co)polymer particles, which are preferably selected from the group of thermoplastic materials comprising polystyrene, polyolefins, in particular polyethylene or polypropylene; polyacrylates, polymethacrylates; polyimides, polycarbonates, polyethersulfones, polyamides, polyesters; and polyvinyl chlorides; styrene-butadiene rubber (SBR); styrene-ethylene-butadiene-styrene copolymers (SEBS); butyl rubber; ethylene-propylene rubber (EPR); ethylene-propylene-diene-monomer rubber (EPDM); ethylene-vinyl acetate copolymer (EVA); ethylene-acrylate or butadiene-acrylonitrile; maleic anhydride modified polymers and copolymers; and graft copolymers; or compositions or mixtures thereof.

6. The switchable element according to any of claims 1 to 5, wherein the colloidal particles are modified particles, and wherein preferably the modified particles are functionalized by at least one organic molecule, preferably by a silane derivative, preferably by 3-aminopropyltriethoxysilane.

7. A method for the preparation of a switchable element as defined in any of claims 1 to 6, comprising the steps of:

   (a) providing colloidal particles, a first material and a second material;
   (b) forming an emulsion comprising the colloidal particles, the first material and the second material from step (a);
   (c) forming first material particles comprising colloidal particles from the emulsion;
   (d) applying the first material particles comprising colloidal particles to the surface of a substrate;
   (e) melting the first material particles comprising colloidal particles on the surface of the substrate,

   wherein the second material is any material which is substantially immiscible with the first material,
   and wherein following melting the first material particles comprising colloidal particles in step e), the first material is solidified to fix the particles in or on the first material.

8. The method according to claim 7, wherein the second material is selected from the group consisting of water, organic solvents, organic solutions and inorganic solutions, preferably of water.

9. A method for preparing a switchable element as defined in any of claims 1 to 6 or prepared according to any of claims 7 and 8, having on a surface a pattern of at least one first area, wherein the colloidal particles have a first degree of immersion, and at least one second area, wherein the colloidal particles have a second degree of immersion different from said first degree of immersion, the method comprising:

   (a) providing a switchable element as defined in any of claims 1 to 6 or prepared according to any of claims 6 and 8;
   (b) treating the first area(s) but not the second area(s), or the second area(s) but not the first area(s) with at least one external stimulus in order to change the degree of immersion of the colloidal particles on the treated area(s) and to produce the pattern on the surface of the switchable element.

10. A method of physical switching the switchable element as defined in any of claims 1 to 6 or prepared according to any of claims 7 to 9, comprising the steps of:

(a) providing the switchable element;
(b) applying at least one external stimulus to the switchable element; wherein the switchable element responds to the at least one external stimulus by changing the degree of immersion of the colloidal particles in the first material.

11. The method according to claim 9 or 10, wherein the external stimulus is selected from the group consisting of temperature, radiation, preferably UV- of IR-radiation, humidity and presence or absence of water in the ambient medium surrounding the switchable element.

12. Use of a switchable element according to any of claims 1 to 6 or prepared according to any of claims 7 to 9 in optoelectronic, sensor or biotechnological applications.

13. Use of a switchable element according to claim 12 for the design of microfluidic devices, functional coatings, logical devices or a pattern.

**Patentansprüche**

1. Schaltbares Element, umfassend ein Substrat, das mit einem ersten Material und kolloidalen Teilchen, die mindestens teilweise in das erste Material eintauchen, bedeckt ist,
wobei das erste Material in einem fluiden Zustand ermöglicht, dass die kolloidalen Teilchen mindestens teilweise in das erste Material eintauchen, und wobei die kolloidalen Teilchen auf einen externen Stimulus, der ihr Ausmaß von Eintauchen in das erste Material verändert, ansprechen, und wobei bei einer Temperatur unter dem Schmelzpunkt des ersten Materials die kolloidalen Teilchen in ihrem Ausmaß von Eintauchen fixiert sind,
wobei das erste Material aus der Gruppe, bestehend aus Polybutylvinylether, Poly-cischlorbutadien, Polyethylenadipat, Polyethylenoxid, Poly-cis-isopren, Poly-transisopren, Propylenoxid, Polyvinylacetal oder Polyvinylbutyral, Polyethylen oder Zusammensetzungen oder Gemischen davon, und aus natürlichem Wachs und synthetischem Wachs, bevorzugt Paraffinen, Siliciumwachsen, Polyetherwachsen und Polyesterwachsen, oder Zusammensetzungen oder Gemischen davon, ausgewählt ist, und wobei die kolloidalen Teilchen einen Durchmesser zwischen 20 nm und 500 nm aufweisen.

2. Schaltbares Element gemäß Anspruch 1, wobei die Schmelztemperatur des ersten Materials 25 bis 150°C, bevorzugt 30 bis 85°C beträgt.

3. Schaltbares Element gemäß einem der Ansprüche 1 bis 2, wobei das Ausmaß von Eintauchen der kolloidalen Teilchen in einem ersten Bereich auf der Oberfläche des schaltbaren Elements unterschiedlich ist vom Ausmaß von Eintauchen in einem zweiten Bereich auf der Oberfläche des schaltbaren Elements.

4. Schaltbares Element gemäß Anspruch 3, wobei erster Bereich und zweite Bereiche in einem Muster an der Oberfläche des schaltbaren Elements angeordnet sind.

5. Schaltbares Element gemäß einem der Ansprüche 1 bis 4, wobei die kolloidalen Teilchen anorganische oder organische Teilchen sind,
wobei die anorganischen Teilchen bevorzugt aus der Gruppe, bestehend aus Metallen, Metalloxiden, Metallhydroxiden, Halbleitermaterialien, nicht-leitenden Materialien und Siliciumdioxid, bevorzugt FeO, $Fe_2O_3$ und $SiO_2$, oder Zusammensetzungen oder Gemischen davon, ausgewählt sind; und
wobei die organischen Teilchen bevorzugt Polymer- oder (Co)polymerteilchen sind, welche bevorzugt aus der Gruppe von thermoplastischen Materialien ausgewählt sind, umfassend Polystyren, Polyolefine, insbesondere Polyethylen oder Polypropylen; Polyacrylate, Polymethacrylate; Polyimide, Polycarbonate, Polyethersulfone, Polyamide, Polyester; und Polyvinylchloride; Styren-Butadien-Kautschuk (SBR); Styren-Ethylen-Butadien-Styren-Copolymere (SEBS); Butylkautschuk; Ethylen-Propylen-Kautschuk (EPR); Ethylen-Propylen-Dien-Monomer-Kautschuk (EPDM); Ethylen-Vinylacetat-Copolymer (EVA); Ethylenacrylat oder Butadienacrylnitril; Maleinsäureanhydrid-modifizierte Polymere und Copolymere; und Pfropfcopolymere; oder Zusammensetzungen oder Gemische davon.

6. Schaltbares Element gemäß einem der Ansprüche 1 bis 5, wobei die kolloidalen Teilchen modifizierte Teilchen sind, und wobei die modifizierten Teilchen bevorzugt durch mindestens ein organisches Molekül, bevorzugt durch ein Silanderivat, bevorzugt durch 3-Aminopropyltriethoxysilan, funktionalisiert sind.

7. Verfahren zur Herstellung eines schaltbaren Elements wie in einem der Ansprüche 1 bis 6 definiert, umfassend die Schritte von:

(a) Bereitstellen von kolloidalen Teilchen, einem ersten Material und einem zweiten Material;
(b) Bilden einer Emulsion, umfassend die kolloidalen Teilchen, das erste Material und das zweite Material von Schritt (a);
(c) Bilden von erstes Material-Teilchen, umfassend kolloidale Teilchen, von der Emulsion;
(d) Aufbringen der erstes Material-Teilchen, umfassend kolloidale Teilchen, auf die Oberfläche eines Substrats;
(e) Schmelzen der erstes Material-Teilchen, umfassend kolloidale Teilchen, auf der Oberfläche des Substrats,

wobei das zweite Material jedwedes Material, das im Wesentlichen mit dem ersten Material nicht mischbar ist, ist, und wobei nach dem Schmelzen der erstes Material-Teilchen, umfassend kolloidale Teilchen, in Schritt e) das erste Material verfestigt wird, um die Teilchen in oder auf dem ersten Material zu fixieren.

8. Verfahren gemäß Anspruch 7, wobei das zweite Material aus der Gruppe, bestehend aus Wasser, organischen Lösungsmitteln, organischen Lösungen und anorganischen Lösungen, bevorzugt aus Wasser, ausgewählt ist.

9. Verfahren zum Herstellen eines schaltbaren Elements wie in einem der Ansprüche 1 bis 6 definiert oder hergestellt gemäß einem der Ansprüche 7 und 8, wobei auf einer Oberfläche davon ein Muster von mindestens einem ersten Bereich, in dem die kolloidalen Teilchen ein erstes Ausmaß von Eintauchen aufweisen, und mindestens einem zweiten Bereich, in dem die kolloidalen Teilchen ein zweites Ausmaß von Eintauchen aufweisen, das unterschiedlich von dem ersten Ausmaß von Eintauchen ist, vorhanden ist, wobei das Verfahren umfasst:

(a) Bereitstellen eines schaltbaren Elements wie in einem der Ansprüche 1 bis 6 definiert oder hergestellt gemäß einem der Ansprüche 6 und 8;
(b) Behandeln des ersten Bereichs bzw. der ersten Bereiche, aber nicht des zweiten Bereichs bzw. der zweiten Bereiche, oder des zweiten Bereichs bzw. der zweiten Bereiche, aber nicht des ersten Bereichs bzw. der ersten Bereiche mit mindestens einem externen Stimulus, um das Ausmaß von Eintauchen der kolloidalen Teilchen in dem behandelten Bereich bzw. den behandelten Bereichen zu verändern und um das Muster auf der Oberfläche des schaltbaren Elements zu erzeugen.

10. Verfahren von physikalischem Schalten des schaltbaren Elements wie in einem der Ansprüche 1 bis 6 definiert oder hergestellt gemäß einem der Ansprüche 7 bis 9, umfassend die Schritte von:

(a) Bereitstellen des schaltbaren Elements;
(b) Aufbringen von mindestens einem externen Stimulus auf das schaltbare Element; wobei das schaltbare Element auf den mindestens einen externen Stimulus durch Verändern des Ausmaßes von Eintauchen der kolloidalen Teilchen in das erste Material anspricht.

11. Verfahren gemäß Anspruch 9 oder 10, wobei der externe Stimulus aus der Gruppe, bestehend aus Temperatur, Strahlung, bevorzugt UV- oder IR-Strahlung, Feuchtigkeit und Gegenwart oder Abwesenheit von Wasser in dem ambienten Medium, welches das schaltbare Element umgibt, ausgewählt ist.

12. Verwendung eines schaltbaren Elements gemäß einem der Ansprüche 1 bis 6 oder hergestellt gemäß einem der Ansprüche 7 bis 9 in optoelektronischen, Sensor- oder biotechnologischen Anwendungen.

13. Verwendung eines schaltbaren Elements gemäß Anspruch 12 für das Design von mikrofluiden Vorrichtungen, funktionellen Beschichtungen, Logik-Vorrichtungen oder eines Musters.

**Revendications**

1. Élément commutable comprenant un substrat recouvert d'un premier matériau et de particules colloïdales, qui sont au moins partiellement immergées dans le premier matériau,
dans lequel le premier matériau dans un état fluide permet aux particules colloïdales d'être au moins partiellement immergées dans le premier matériau, et dans lequel les particules colloïdales répondent à un stimulus externe qui change leur degré d'immersion dans le premier matériau, et dans lequel à une température inférieure au point de fusion du premier matériau les particules colloïdales présentent un degré d'immersion fixe,

dans lequel le premier matériau est choisi dans le groupe constitué du polybutylvinyléther, du poly-cis-chlorobutadiène, de l'adipate de polyéthylène, de l'oxyde de polyéthylène, du poly-cis-isoprène, du poly-trans-isoprène, de l'oxyde de propylène, du polyvinylacétal ou du polyvinylbutyral, du polyéthylène ou des compositions ou des mélanges de ceux-ci, et de la cire naturelle et de la cire synthétique, de préférence des paraffines, des cires de silicone, des cires de polyéther et des cires de polyester, ou des compositions ou des mélanges de celles-ci, et dans lequel les particules colloïdales ont un diamètre entre 20 nm et 500 nm.

2. Élément commutable selon la revendication 1, dans lequel la température de fusion du premier matériau est de 25 à 150 °C, de préférence de 30 à 85 °C.

3. Élément commutable selon l'une quelconque des revendications 1 à 2, dans lequel le degré d'immersion des particules colloïdales dans une première zone sur la surface de l'élément commutable est différent du degré d'immersion dans une seconde zone sur la surface de l'élément commutable.

4. Élément commutable selon la revendication 3, dans lequel la première zone et les secondes zones sont agencées selon un motif à la surface de l'élément commutable.

5. Élément commutable selon l'une quelconque des revendications 1 à 4, dans lequel les particules colloïdales sont des particules inorganiques ou organiques,

dans lequel les particules inorganiques sont de préférence choisies dans le groupe constitué des métaux, des oxydes de métal, des hydroxydes de métal, des matériaux semi-conducteurs, des matériaux non conducteurs et de la silice, de préférence du $FeO$, du $Fe_2O_3$ et du $SiO_2$, ou des compositions ou des mélanges de ceux-ci ; et dans lequel les particules organiques sont de préférence des particules de polymère ou de (co)polymère, qui sont de préférence choisies dans le groupe constitué des matériaux thermoplastiques comprenant le polystyrène, les polyoléfines, en particulier le polyéthylène ou le polypropylène ; des polyacrylates, des polyméthacrylates ; des polyimides, des polycarbonates, des polyéthersulfones, des polyamides, des polyesters ; et des chlorures de polyvinyle ; du caoutchouc de styrène-butadiène (SBR) ; des copolymères de styrène-éthylène-butadiène-styrène (SEBS) ; du caoutchouc de butyle ; du caoutchouc d'éthylène-propylène (EPR) ; du caoutchouc d'éthylène-propylène-diène monomère (EPDM) ; du copolymère d'éthylène-acétate de vinyle (EVA) ; d'éthylène-acrylate ou de butadiène-acrylonitrile ; des polymères et copolymères modifiés par de l'anhydride maléique ; et des copolymères greffés ; ou des compositions ou des mélanges de ceux-ci.

6. Élément commutable selon l'une quelconque des revendications 1 à 5, dans lequel les particules colloïdales sont des particules modifiées, et dans lequel de préférence les particules modifiées sont fonctionnalisées par au moins une molécule organique, de préférence par un dérivé de silane, de préférence par le 3-aminopropyltriéthoxysilane.

7. Procédé de préparation d'un élément commutable tel que défini dans l'une quelconque des revendications 1 à 6, comprenant les étapes de :

(a) fourniture de particules colloïdales, d'un premier matériau et d'un second matériau ;
(b) formation d'une émulsion comprenant les particules colloïdales, le premier matériau et le second matériau de l'étape (a) ;
(c) formation de particules du premier matériau comprenant des particules colloïdales à partir de l'émulsion ;
(d) application des particules du premier matériau comprenant des particules colloïdales sur la surface d'un substrat ;
(e) fusion des particules du premier matériau comprenant des particules colloïdales sur la surface du substrat,

dans lequel le second matériau est tout matériau qui est sensiblement immiscible avec le premier matériau, et dans lequel après la fusion des particules du premier matériau comprenant des particules colloïdales à l'étape e), le premier matériau est solidifié pour fixer les particules dans ou sur le premier matériau.

8. Procédé selon la revendication 7, dans lequel le second matériau est choisi dans le groupe constitué de l'eau, des solvants organiques, des solutions organiques et des solutions inorganiques, de préférence de l'eau.

9. Procédé de préparation d'un élément commutable tel que défini dans l'une quelconque des revendications 1 à 6 ou préparé selon l'une quelconque des revendications 7 et 8, ayant sur une surface un motif d'au moins une première zone, dans laquelle les particules colloïdales présentent un premier degré d'immersion, et d'au moins une seconde zone, dans laquelle les particules colloïdales présentent un second degré d'immersion différent dudit premier degré d'immersion, le procédé comprenant :

(a) la fourniture d'un élément commutable tel que défini dans l'une quelconque des revendications 1 à 6 ou préparé selon l'une quelconque des revendications 6 et 8 ;

(b) le traitement de la (des) première(s) zone(s) mais pas de la (des) seconde (s) zone(s), ou de la (des) seconde(s) zone(s) mais pas de la (des) première(s) zone(s), avec au moins un stimulus externe afin de changer le degré d'immersion des particules colloïdales sur la (les) zone(s) traitée(s) et de produire le motif sur la surface de l'élément commutable.

10. Procédé de commutation physique de l'élément commutable tel que défini dans l'une quelconque des revendications 1 à 6 ou préparé selon l'une quelconque des revendications 7 à 9, comprenant les étapes de :

(a) fourniture de l'élément commutable ;

(b) application d'au moins un stimulus externe sur l'élément commutable ; l'élément commutable répondant à l'au moins un stimulus externe en changeant le degré d'immersion des particules colloïdales dans le premier matériau.

11. Procédé selon la revendication 9 ou 10, dans lequel le stimulus externe est choisi dans le groupe constitué de la température, d'un rayonnement, de préférence d'un rayonnement UV ou IR, de l'humidité et de la présence ou de l'absence d'eau dans le milieu ambiant entourant l'élément commutable.

12. Utilisation d'un élément commutable selon l'une quelconque des revendications 1 à 6 ou préparé selon l'une quelconque des revendications 7 à 9 dans des applications optoélectroniques, de capteur ou biotechnologiques.

13. Utilisation d'un élément commutable selon la revendication 12 pour la conception de dispositifs microfluidiques, de revêtements fonctionnels, de dispositifs logiques ou d'un motif.

after annealing on air     after annealing in water

hydrophilic particles

wax

Fig. 1

Fig. 2

Fig. 3

**Fig. 4**

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7020335 B2
- US 20070190299 A1
- US 20070190327 A1

### Non-patent literature cited in the description

- **WENZEL, R. N.** *Ind. Eng. Chem. Res.,* 1936, vol. 28, 988
- **MARMUR, A.** *Langmuir,* 2003, vol. 19, 8343
- **MARMUR, A.** *Langmuir,* 2004, vol. 20, 3517
- **CASSIE, A. B. D. ; BAXTER, S.** *Trans. Faraday Soc.,* 1944, vol. 40, 546
- **MINKO, S. ; MULLER, M. ; MOTORNOV, M. ; NITSCHKE, M. ; GRUNDKE, K. ; STAMM, M.** *Journal of the American Chemical Society,* 2003, vol. 125, 3896
- Conformal switchable superhydrophobic/hydrophilic surfaces for microscale flow control. **CHUNDER A et al.** COLLOIDS AND SURFACES. A, PHYSICACHEMICAL AND ENGINEERING ASPECTS. ELSEVIER, 05 February 2009, vol. 333, 187-193
- **SIDORENKO, A. ; KRUPENKIN, T. ; TAYLOR, A. ; FRATZL, P. ; AIZENBERG, J.** *Science,* 2007, vol. 315, 487
- **SYNYTSKA, A. ; IONOV, L. ; DUTSCHK, V. ; STAMM, M. ; GRUNDKE, K.** *Langmuir,* 2008, vol. 24, 11895